# EUROPÄISCHE PATENTSCHRIFT

(11) **EP 1 808 853 B1**
(45) Veröffentlichungstag und Bekanntmachung des Hinweises auf die Patenterteilung: **14.05.2014**
(21) Anmeldenummer: 07100022.8
(22) Anmeldetag: 02.01.2007
(51) Int. Cl.: G10L 21/02, H04R 27/00, H03G 3/32

(54) **Beschallungsanlage, Beschallungsverfahren und Computerprogramm zur Verbesserung der Sprachqualität und/oder Verständlichkeit von Sprachdurchsagen**
Public address system, method and computer program to enhance the speech intelligibility of spoken messages
Dispositif et procédé pour améliorer l'intelligibilité d'un système de sonorisation, et programme informatique

(30) Priorität: 13.01.2006 DE 102006001730
(43) Veröffentlichungstag der Anmeldung: 18.07.2007
(73) Patentinhaber: ROBERT BOSCH GMBH, 70442 Stuttgart (DE)
(72) Erfinder: Lietz, Stephan, 31162 Bad Salzdetfurth (DE); Dahlhoff, Achim, 31141 Hildesheim (DE)

(56) Entgegenhaltungen:
- WO-A-96/29779
- WO-A-02/076149
- GB-A- 2 327 835
- SAVCHAK M W ET AL INSTITUTE OF ELECTRICAL AND ELECTRONICS ENGINEERS: "A new public address system for a renovated Grand Central Terminal" PROCEEDINGS OF THE 2000 ASME/IEEE JOINT RAILROAD CONFERENCE. NEWARK, NJ, APRIL 4 - 6, 2000, PROCEEDINGS OF THE ASME/IEEE JOINT RAILROAD CONFERENCE, NEW YORK, NY : IEEE, US, 4. April 2000 (2000-04-04), Seiten 179-194, XP010512404 ISBN: 0-7803-6328-0
- FIZGERALD B ET AL: "Development of the DLR Smartsound noise adaptive public address control system" IEE ADVANCES IN RAILWAY COMMUNICATION SYSTEMS, 11. Dezember 1997 (1997-12-11), Seiten 1-6, XP006506698 London, UK

## Beschreibung

### Stand der Technik

Die Erfindung betrifft eine Beschallungsanlage mit einem ersten Audioeingang für Nutzsignale, mit einem zweiten Audioeingang für Störsignale, mit einem Audioausgang für modifizierte Nutzsignale und mit einer Abgleichvorrichtung, die programm- und/oder schaltungstechnisch für den Abgleich der Nutzsignale mit den Störsignalen ausgebildet ist, so dass die modifizierten Nutzsignale erzeugbar sind und/oder erzeugt werden, sowie ein entsprechendes Verfahren und Computerprogramm.

Beschallungsanlagen werden üblicherweise in öffentlichen Gebäuden oder Plätzen, Flughäfen, Bahnhöfen etc. installiert und dienen dazu, Besuchern oder Passanten Informationen meist in Form von Sprachdurchsagen zu übermitteln. Übliche Beschallungsanlagen bestehen aus einer oder mehreren Audioquellen, zum Beispiel Mikrofonen, einem oder mehreren Audioverstärkern sowie einer Vielzahl von Lautsprechern, die in dem zu beschallenden Bereich verteilt sind. Um den technischen Aufwand zu minimieren soll einerseits ein möglichst großer Bereich mit wenigen Lautsprechern abgedeckt werden und andererseits der gesamte Abdeckungsbereich eine gute Verständlichkeit der Ansagen garantieren.

Eine technische Herausforderung bei den Beschallungsanlagen ist darin zu sehen, dass die Umgebungssituation für die Beschallungsanlagen sehr unterschiedlich sein können. So werden derartige Anlage an ruhigen Orten, wie zum Beispiel Wartezimmer in Arztpraxen, aber auch in sehr lauten Umgebungen, wie z.B. Flughäfen oder Bahnhöfen installiert. Die auftretenden Störgeräusche können stationären oder konstant ausgebildet sein, wie z.B. Maschinengeräusche oder gleichmäßiges Stimmengemurmel, aber auch sehr dynamisch sein, wie z.B. bei einem in einen Bahnhof einfahrenden Zug oder bei einem startenden oder landenden Flugzeug. Unter allen diesen Bedingungen sollen Beschallungsanlagen eine gute Sprachverständlichkeit garantieren.

Die Druckschrift EP 0993670 B1 betrifft ein Verfahren und eine Vorrichtung zur Sprachverbesserung in einem Sprachübertragungssystem. Als mögliche Anwendungsbeispiele sind Mobiltelefone, Radios oder Fernsehgeräte genannt, die oftmals in lauten Umgebungen verwendet werden. In der genannten Druckschrift wird vorgeschlagen, dass der Hintergrundgeräuschpegel in der direkten Nähe eines Hörers aufgenommen wird und ein übertragenes Sprachsignal unter Berücksichtigung des Hintergrundgeräuschpegels modifiziert wird. Es erfolgt somit eine spezifisch angepasste Beschallung des Hörers unter Berücksichtigung der individuellen akustischen Umgebung.

Die Druckschrift GB2 327 835 A offenbart eine Vorrichtung und ein Verfahren zur Verbesserung der Sprachverständlichkeit, insbesondere für Kleingeräte wie Mobiltelefone und Radios in geräuschbelasteten Umgebungen, wie z. B. in Fahrzeugen.

Die Druckschrift WO 02/076149, die den nächstkommenden Stand der Technik bildet, betrifft ein Verfahren und eine Vorrichtung zum Betreiben von Beschallungsanlagen, bei welchen von einer analogen Signalquelle ausgehende Signale verstärkt und an die einzelnen Lautsprecher einer Beschallungsanlage übermittelt und von diesen ausgegeben werden. Um ein Verfahren bzw. eine Vorrichtung zum Betrieben einer solchen Beschallungsanlage bereitzustellen, die einen erheblich geringeren apparativen Aufwand haben und gleichzeitig auch einfachere und weniger aufwendige Möglichkeiten bieten, den ausgegebenen Schall auch im Verhältnis zu Umgebungsgeräuschen besser zu kontrollieren, wird in dieser Druckschrift vorgeschlagen, dass die von der Signalquelle ausgehenden Signale digitalisiert und über ein digitales Netzwerk an Schnittstellen einzelner Lautsprecher oder Gruppen von Lautsprechern übermittelt, ausgewertet, in analoge Signale zurückgewandelt werden und dann über den bzw. die Lautsprecher ausgegeben werden.

### Offenbarung der Erfindung

Erfindungsgemäß wird eine Beschallungsanlage mit den Merkmalen des Anspruchs 1, ein Verfahren zur Verbesserung der Sprachqualität und/oder Verständlichkeit von Sprachdurchsagen mit den Merkmalen des Anspruchs 9 und ein entsprechendes Computerprogramm mit den Merkmalen des Anspruchs 10 vorgeschlagen. Die Unteransprüche betreffen bevorzugte und/oder vorteilhafte Ausführungsformen der Erfindung.

Die Beschallungsanlage - insbesondere auch Public Address System genannt - dient bevorzugt den Anwendungen, die bereits einleitend dargestellt wurden. Vorzugsweise stellt die Beschallungsanlage sicher, dass auch im Falle eines Alarms, zum Beispiel eines Feueralarms, die Verständlichkeit von Ansagen gewährleistet bleibt, damit Personen sicher aus einem Gefährdungsgebiet geleitet werden können.

Die Beschallungsanlage weist einen ersten Audioeingang für Nutzsignale, einen zweiten Audioeingang für Störsignale und ein Audioausgang für modifizierte Nutzsignale auf. Diese Schnittstellen sind mindestens einfach ausgebildet. Vorzugsweise ist eine beliebige der Schnittstellen und/oder alle Schnittstellen mehrfach realisiert.

Für den Abgleich des Nutzsignals mit dem Störsignal ist eine Abgleichvorrichtung ausgebildet, die zur Erzeugung der modifizierten Nutzsignale dient. Der Abgleich der Nutzsignale erfolgt insbesondere so, dass von einem Hörer die modifizierten Nutzsignale in Gegenwart der Störsignale besser als die unmodifizierten Nutzsignale wahrgenommen werden können. Bevorzugt erfolgt der Abgleich unter Ausnutzung von psychoakustischen Eigenschaften des menschlichen Gehörs und/oder durch einen Vergleich der Nutzsignale mit den Störsignalen, insbesondere unter Berücksichtigung der Frequenzen, Amplituden, Formanten, Vokalen, Konsonanten, Sprachpausen usw.

Erfindungsgemäß ist die Beschallungsanlage zur gleichmäßigen Beschallung von ausgedehnten Bereichen ausgebildet. Eine gleichmäßige Beschallung liegt vor, wenn die modifizierten Nutzsignale von mindestens zwei Audioquellen ausgestrahlt werden, die voneinander beabstandet sind. Ausgedehnte Bereiche für eine Beschallungsanlage im Sinne der Erfindung sind Bereiche, in denen sich eine Vielzahl von Personen aufhalten und frei bewegen können. Beispiele für ausgedehnte Bereiche sind große Räume, öffentliche Gebäude, Bahnhöfe, Flughäfen usw..

Die Erfindung geht dabei von der Überlegung aus, dass eine Verbesserung der Sprachqualität auch bei Anlagen sinnvoll ist, die gänzlich andere technische Randbedingungen aufweisen, als die aus dem Stand der Technik bekannten Klein- und Kleinstgeräte.

Bei einer bevorzugten Ausführungsform der Erfindung enthalten die Störsignale Informationen über die örtliche Verteilung der Störgeräusche in den zu beschallenden Bereichen und/oder sind aus Signalen mit derartigen Informationen gebildet. Eine mögliche Realisierung liegt vor, wenn der zweite Audioeingang ein mehrkanaliges Störsignal aufnimmt bzw. entsprechend ausgebildet ist, wobei jeder Kanal einer Störgeräuschaufnahmevorrichtung, z.B. einem Mikrofon, zugeordnet ist. Eine Abwandlung liegt vor, wenn der zweite Audioeingang Schnittstellen für eine Vielzahl von Störgeräuschaufnahmevorrichtungen aufweist. Eine alternative Realisierung ist gegeben, wenn Mittel vorgesehen sind, um ein mehrkanaliges Störsignal z.B. durch einfache Addition zu einem einkanaligen Störsignal zu verarbeiten, welches anschließend dem zweiten Audioeingang und/oder der Abgleichvorrichtung zugeführt wird.

Diese Ausführungsform unterstreicht die erfinderische Idee, die Beschallungsanlage für ausgedehnte Bereiche auszubilden, wobei durch die Störsignalaufnahme über insbesondere voneinander beabstandete Störgeräuschaufnahmevorrichtungen sichergestellt ist, dass die Störsignale in Abhängigkeit der räumlichen Verteilung der Störgeräusche gebildet sind.

Bevorzugt sind die Nutzsignale als Sprachsignale, insbesondere in Form einer Durchsage, und/oder die Störsignale als insbesondere stationäre und/oder konstante und/oder dynamische und/oder nicht-stationäre Umgebungsgeräusche ausgebildet.

Von der konstruktiven Seite betrachtet, weist die Beschallungsanlage bevorzugt eine Hauptstation, welche den ersten Audioeingang umfasst, und eine Nebenstation auf, wobei die Nebenstation die Abgleichvorrichtung und/oder den zweiten Audioeingang und/oder den Audioausgang umfasst und vorzugsweise als Lautsprechereinheit ausgebildet ist. Hauptstation und Nebenstation sind insbesondere über ein Netzwerk verbunden. Bevorzugt umfasst die Beschallungsanlage mehrere Hauptstationen und/oder mehrere Nebenstationen, die insbesondere über das Netzwerk verbunden sind. Das Netzwerk ist bevorzugt zur Übertragung von digital kodierten Daten, insbesondere in Form von Bits und Bytes ausgebildet. Die Aufteilung der Beschallungsanlage in getrennte Funktionseinheiten, die über ein Netzwerk verbunden sind, erlaubt die Skalierung der Beschallungsanlage, so dass ohne großen technischen Aufwand, weitere Nebenstationen und/oder Hauptstationen in vorhandene Beschallungsanlagen integriert werden können. Eine Mehrzahl über Netzwerk verbundene Hauptstationen eröffnet die Möglichkeit, dass die Quelle für das Nutzsignal beliebig gewechselt werden kann und somit beispielsweise Durchsagen über die Beschallungsanlage von verschiedenen Orten durchgeführt werden können. Insbesondere kann das Netzwerk oder Abschnitte davon kabellos ausgebildet sein, so dass beispielsweise die Hauptstation ohne Verkabelung von einem Sprecher beweglich mitgeführt werden kann. In einer vereinfachten Ausführungsform erfolgt die Datenübertragung von der oder den Hauptstationen zu dem oder den Nebenstationen über analoge Signalleitungen.

Bei einer vorteilhaften Weiterbildung umfasst die Beschallungsanlage ein Analysemodul, welches programmtechnisch und/oder schaltungstechnisch zur Erzeugung von Meta-Daten (Meta Data) über die Nutzsignale, insbesondere die Sprachsignale, ausgebildet ist. Diese Meta-Daten sind Informationen über die Nutzsignale und umfassen vorzugsweise nicht das Nutzsignal. Diese zusätzlichen Informationen betreffen insbesondere die zeitliche Lage und/oder elektrische Parameter und/oder Frequenzinformationen von Signalteilen wie Vokale, Konsonanten, Formanten, Sprachpausen usw. Optional werden Informationen über stimmlose und stimmhafte Bereiche (unvoiced and voiced speech) der Sprachsignale bereitgestellt. Das Analysemodul ist bevorzugt als Teil der Hauptstation und/oder als Teil der Nebenstation und/oder als zusätzlicher Netzwerkknoten ausgebildet. Bei der Alternative, dass das Analysemodul als Teil der Hauptstation und/oder im Signalweg vor dem Netzwerk und/oder vor den analogen Signalleitungen und/oder als zusätzlicher Netzwerkknoten ausgebildet ist, ist der Vorteil gegeben, dass die rechenintensive Analyse des Nutzsignals in einem zentralen Spracheingabegerät und/oder in einem Central Controller durchgeführt wird und die Nebenstationen vom Rechenaufwand entlastet werden und entsprechend kostengünstigere Verarbeitungseinheiten in den Nebenstationen einsetzbar sind. Bei der Alternative, dass das Analysemodul in einer Nebenstation angeordnet ist, ist eine mögliche Ausbildung, dass jede Nebenstation ein Analysemodul aufweist und somit Nebenstationen besonders einfach an das Netzwerk oder die analogen Signalleitungen ankoppelbar sind. Eine andere mögliche Ausbildung liegt vor, wenn nur eine Nebenstation das Analysemodul umfasst und die Meta-Daten z. B. über das Netzwerk an die anderen Nebenstationen weiterführt.

Bei einer vorteilhaften Weiterbildung weist die Nebenstation und/oder alle Nebenstation ein Vorverarbeitungsmodul auf, welches schaltungstechnisch und/oder programmtechnisch zur Vorverarbeitung und/oder Filterung und/oder Echo- oder Halleliminierung des Störsignals bzw. in den Störsignalen ausgebildet ist. Das Vorverarbeitungsmodul weist bevorzugt Signaleingänge auf, die mit dem zweiten Audioeingang und optional mit dem Audioausgang verschaltet sind. Die optionale Verbindung mit dem Audioausgang ermöglicht eine besonders effektive Herausfilterung von Hall und Echo der aktuell ausgestrahlten Nutzsignale sowie der Nutzsignale selbst aus den Störsignalen.

Die Beschallungsanlage weist ein Schätzmodul auf, welches schaltungstechnisch und/oder programmtechnisch zur Prädiktion des Störsignals für einen zukünftigen Zeitpunkt ausgebildet ist. Vorzugsweise ist das Schätzmodul realisiert, so dass in einem ersten Schritt aus den von dem Vorverarbeitungsmodul gelieferten Signalen der aktuelle Störteppich im Versorgungsbereich der Beschallungsanlage und/oder der Nebenstation und/oder Nebenstationen berechnet wird. In einem zweiten Schritt wird der weitere zeitliche Verlauf des Störteppichs geschätzt. Hierzu wird beispielsweise eine statistische Analyse auf der Basis vordefinierter Daten genutzt, die gegebenenfalls durch eigene Werte während des Betriebes der Nebenstation ergänzt oder geändert werden. Alternativ oder ergänzend können Algorithmen wie prädiktive, adaptive Filter wie z.B. Kalman-Filter eingesetzt werden. Der Zeitrahmen der zeitlichen Schätzung, also die Prädiktionsdauer, entspricht der Zeit und/oder ist an die Zeit gekoppelt, die benötigt wird, um die Nutzsignale zu modifizieren und vorzugsweise zzgl. der Zeit für die Schallausbreitung im Raum. Die Modifikation des Nutzsignale erfordert eine gewisse Zeitspanne, so dass Änderungen erst zu einem späteren Zeitpunkt als die Messung der Störsignale und/oder Umgebungsgeräusche wirksam werden können.

Optional oder ergänzend ist das Schätzmodul programmtechnisch und/oder schaltungstechnisch zur Bewertung der Überdeckung und/oder Maskierung des Nutzsignals durch das Störsignal und/oder durch das prädiktierte Störsignal ausgebildet. Hierbei wird insbesondere ermittelt, welche Anteile des Nutzsignals, insbesondere der Sprachdurchsage, durch das prädiktierte Signal gestört werden könnten. Vorzugsweise wird aus den Störsignalen und/oder modifizierten Störsignalen eine zeit-, frequenz- und/oder amplitudenabhängige Überdeckungsverteilung gebildet, die angibt, für welche spektralen Anteile zu welcher Zeit eine Überdeckung eines Signals eintritt. Die Überdeckungsverteilung ist so ausgelegt, dass sie für den gesamten Versorgungsbereich der Beschallungsanlage und/oder der Nebenstation und/oder Nebenstationen repräsentativ ist. Insbesondere umfasst die Überdeckungsverteilung eine gestufte und/oder gleitende Aussage über den Grad der Überdeckung sowie über die geschätzte Zeitdauer der Überdeckung.

Bei einer bevorzugten Ausführungsform ist die Abgleichvorrichtung programmtechnisch und/oder schaltungstechnisch ausgebildet, so dass Informationen und/oder Signale aus dem Analysemodul, insbesondere die Meta-Daten, und dem Schätzmodul, insbesondere die Überdeckungsverteilung, für den Abgleich als Eingangsdaten vorliegen. Basierend auf diesen Eingangsdaten und den Nutzsignalen werden die spektralen Nutzsignalanteile, die von einer Überdeckung betroffen wären, ermittelt und derart modifiziert, so dass eine gute Verständlichkeit und/oder Sprachqualität gewahrt ist und/oder diese erhöht wird.

Bei der Modifikation des Nutzsignals werden insbesondere die überdeckten oder maskierten Nutzsignalanteile verstärkt. Alternativ oder ergänzend werden die für die Verständlichkeit wichtigen Konsonanten oder Formanten etc. verstärkt werden. Bei weiteren Ausführungsformen werden alternativ oder ergänzend die Frequenzen der Nutzsignale verschoben, um den spektralen Überdeckungsbereichen quasi auszuweichen. Ebenfalls ist eine Kombination der genannten Maßnahmen möglich, insbesondere können z.B. die überdeckten und/oder teilüberdeckten spektralen Anteile und eine Auswahl von Formanten verstärkt werden.

Optional wird das Nutzsignal in der Abgleichvorrichtung zwischengespeichert, um eine zeitliche Korrelation zwischen geschätztem Störsignal und der Ausgabe des modifizierten Nutzsignals zu erreichen.

Ergänzend umfasst die Beschallungsanlage einen Dynamikkompressor, wobei leise Passagen der Nutzsignale in dem Pegel verstärkt werden und laute Passagen unverändert bleiben oder diese gedämpft werden. Diese Maßnahme führt ebenfalls zu einer Verbesserung der Sprachverständlichkeit aufgrund einer Anhebung der wichtigen Konsonanten. Ein weiterer Vorteil der Dynamik-Kompression ist eine bessere Auslastung der Audioverstärker und Lautsprecher.

Die Erfindung betrifft ferner ein Verfahren zur Verbesserung der Sprachqualität und/oder der Verständlichkeit von Sprachdurchsagen mit den Merkmalen des Anspruchs 9, wobei ein Abgleich von Nutzsignalen mit Störsignalen erfolgt und wobei der zeitliche Verlauf der Störsignale für einen zukünftigen Zeitpunkt vorausberechnet wird. Zudem betrifft die Erfindung ein Computerprogramm mit den Merkmalen des Anspruchs 10, welches zur Ausführung des Verfahrens ausgebildet ist.

Der Vorteil der Erfindung liegt insgesamt darin, dass Durchsagen im Falle von erhöhtem Umgebungsgeräuschpegel wie z.B. schreienden Menschen, Fahrzeuggeräuschen usw. besser verstanden werden. Die Störgeräusche können dabei stationären oder nichtstationären Charakter haben. Wichtige alternative oder ergänzende Merkmale der Erfindung oder Weiterbildungen der Erfindung sind, dass die Störgeräusche für einen zukünftigen Zeitpunkt vorausberechnet bzw. geschätzt werden, dass es keine vordefinierte Schwelle zwischen den Zuständen "verständlich" und "unverständlich" bei der Beurteilung des Nutzsignals gibt, dass der Ort der Messung der Störgeräusche nicht gleich dem Aufenthaltsort der Hörer ist und/oder dass eine Modifikation des ursprünglichen Sprachsignals (Nutzsignals) kontinuierlich oder dynamisch stattfindet. Vorteilhaft ist zudem, dass ein Public Address System nach der vorliegenden Erfindung bei gleicher Sprachverständlichkeit mit schwächeren Audio-Verstärkern auskommt als ein herkömmliches System, wodurch die Kosten für diese Systeme sinken. Zugleich wird durch die Erfindung die Verständlichkeit von Sprachdurchsagen gerade in Situation erhöht, in denen diese besonders gefordert ist, wie z.B. bei der Evakuierung von Personen aus gefährdeten Bereichen.

Weitere Merkmale und Vorteile der Erfindung ergeben sich aus der nachfolgenden Beschreibung bevorzugter Ausführungsbeispiele und den Figuren. Dabei zeigen:
- Fig. 1: ein erstes Ausführungsbeispiel einer erfindungsgemäßen Beschallungsanlage;
- Fig. 2: eine schematische Blockdarstellung des Ausführungsbeispiels in Figur 1.

Einander entsprechende Teile sind in den Figuren jeweils mit den gleichen Bezugszeichen versehen.

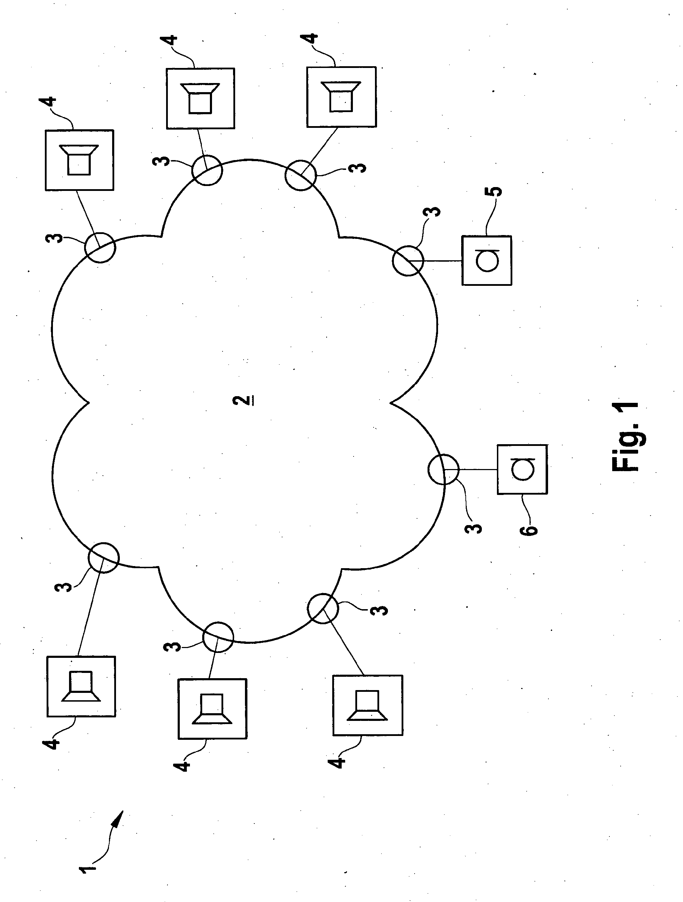

Figur 1 zeigt ein erstes Ausführungsbeispiel einer erfindungsgemäßen Beschallungsanlage 1 mit einem Netzwerk 2 zur Signalübertragung. Das Netzwerk 2 ist in Ringarchitektur aufgebaut, bei abgewandelten Ausführungsformen kann das Netzwerk 2 auch eine Baumstruktur oder andere Topologien aufweisen. Bevorzugt ist das Netzwerk 2 echtzeitfähig ausgebildet. Das Netzwerk 2 weist eine Vielzahl von Netzwerkknoten 3 auf, an denen verschiedene Funktionsgruppen der Beschallungsanlage 1 angeschlossen sind. Einige Funktionsgruppen sind als Lautsprechereinheiten 4 ausgebildet und arbeiten als Nebenstationen in dem Netzwerk 2. Diese Lautsprechereinheiten 4 weisen Audioausgänge zur Ausgabe von modifizierten Sprachdurchsagen auf und sind mit Lautsprechern (nicht dargestellt) verkoppelt. In dem Netzwerk 2 ist mindestens eine Hauptstation 5 vorgesehen, die mit einer Quelle für Sprachdurchsagen, im einfachsten Fall mit einem Mikrofon gekoppelt und/oder koppelbar ist. Zudem sind Mikrofone 6 zur Aufnahme von Umgebungsgeräuschen in den zu beschallenden Bereichen an das Netzwerk 2 gekoppelt.

Die Beschallungsanlage 1 wird aufgebaut, wobei in den zu beschallenden Bereichen jeweils mindestens ein Mikrofon 6 vorzugsweise mindestens zwei Mikrofone 6 angeordnet wird, so dass die Umgebungsgeräusche räumlich und/oder mindestens in Stereo erfasst werden. Bevorzugt sind die Mikrofone 6 in dem zu beschallenden Bereich an insbesondere diametral gegenüberliegenden Positionen angeordnet. Jedem zu beschallendem Bereich ist mindestens eine Lautsprechereinheit 4 mit mehreren Lautsprechern oder mehrere Lautsprechereinheiten 4 mit einem oder mehreren Lautsprechern zugeordnet. Die Lautsprecher sind in dem zu beschallenden Bereich so angeordnet, dass eine gleichmäßige Beschallung mit mindestens zwei voneinander beabstandeten, insbesondere in dem zu beschallenden Bereich diametral und/oder gegenüberliegend angeordneten Lautsprechern erreicht wird. Bei manchen Ausführungsformen sind die Lautsprecher und ein Mikrofon 6 in einer Lautsprechereinheit 4 zusammengefasst.

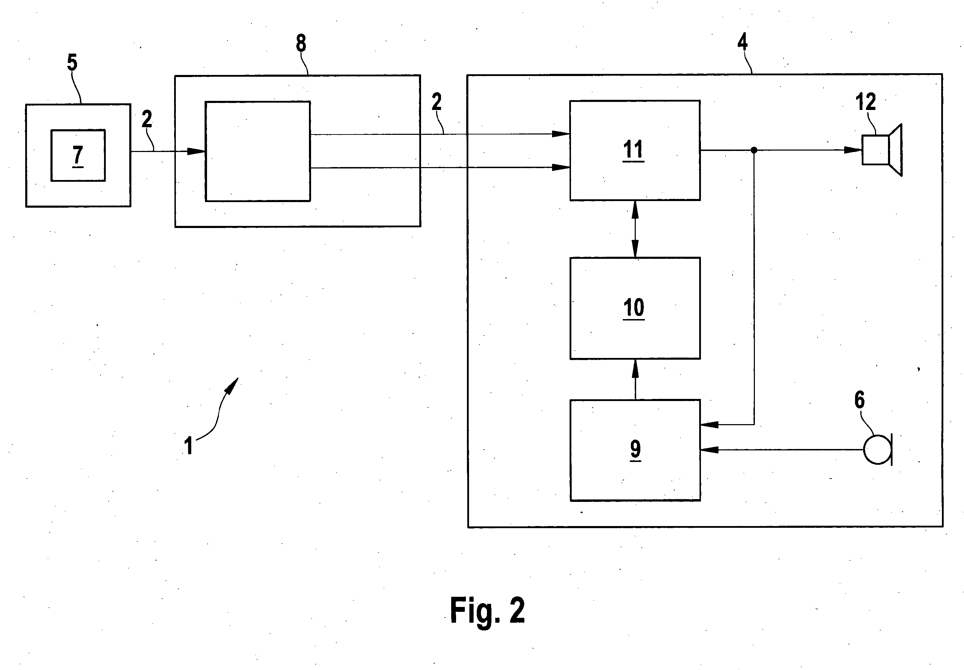

Die Funktionsweise der Beschallungsanlage 1 wird nachfolgend anhand der Blockdarstellung in Figur 2 erläutert:

Die Beschallungsanlage 1 weist eine Hauptstation 5 mit einer Sprachquelle 7 auf. Die Sprachquelle 7 kann als Mikrofon aber auch als Sprachrekorder oder Computer mit gespeicherten Durchsagen ausgebildet sein. Optional sind mehrere Hauptstationen 5 in der Beschallungsanlage 1 vorgesehen. Das Sprachsignal wird über ein Netzwerk 2 an ein Analysemodul 8 übertragen, in dem Meta-Daten über das Sprachsignal gebildet werden. Die Meta-Daten umfassen beschreibende Informationen über das Sprachsignal wie z.B. zeitliche Lage oder elektrische Parameter von Signalteilen wie Vokale, Konsonanten, Formanten etc.. Das Sprachsignal und die Metadaten werden über das Netzwerk 2 an die Lautsprechereinheit(en) 4 übertragen. Bei alternativen Ausführungsformen ist das Analysemodul 8 integraler Bestandteil der Hauptstation 5 oder der Lautsprechereinheit 4.

Die Lautsprechereinheit 4 weist drei Funktionsgruppen auf und zwar ein Vorverarbeitungsmodul (preprocessing) 9, ein Schätzmodul 10 (ambience sound analysis & forward estimation) und eine Abgleichvorrichtung 11 (sound adjustment).

Das Vorverarbeitungsmodul 9 empfängt über Mikrofone 6, die integraler Bestandteil der Nebenstation und/oder separat angeordnet sind, aktuelle Umgebungsgeräusche aus dem zu beschallenden Bereich. Diese Umgebungsgeräusche werden auch als Störsignale bezeichnet. Die Störsignale werden gefiltert, wobei insbesondere das aktuell ausgestrahlte Nutzsignal sowie dessen Hall und/oder Echo ausgefiltert wird. Zur Verbesserung der Signalbearbeitung wird dem Vorverarbeitungsmodul 9 optional das aktuell ausgestrahlte Nutzsignal zugeführt. Das Ergebnis der Vorverarbeitung wird in Form eines gefilterten Störsignals an das Schätzmodul 10 übergeben.

In dem Schätzmodul 10 wird auf Basis des gefilterten Störsignals der aktuelle Störteppich im Versorgungsgebiet der Lautsprechereinheit 4 berechnet und der weitere zeitliche Verlauf des Störteppichs geschätzt. Die Schätzung erfolgt beispielsweise über eine statistische Analyse oder die Berechnung von adaptiven Übertragungsfunktionen oder Kalman-Schätzern. Die Dauer des geschätzten Verlaufs ist in der Länge an die Zeit angepasst, die zur Modifikation des Nutzsignals in der Abgleichvorrichtung 11 benötigt wird und vorzugsweise zzgl. der Zeit, die für die Schallausbreitung im Raum benötigt wird. Für den Störteppich und/oder für den geschätzten zukünftigen Verlauf des Störteppichs werden Schwellwertkurven berechnet, die die Information beinhalten, zu welcher Zeit in welchem Ausmaß eine Überdeckung eines Nutzsignals eintreten könnte. Die Schwellwertkurven sind dabei derart ausgelegt, dass sie den gesamten zu beschallenden Bereich repräsentieren. Die berechneten Schwellwertkurven beinhalten insbesondere nicht nur eine Ja/Nein Entscheidung über die Überdeckung, sondern umfassen auch Zwischenschritte und/oder die geschätzte Zeitdauer der Überdeckung.

Die Meta-Daten, das Nutzsignal und die Schwellwertkurven werden der Abgleichvorrichtung 11 zugeführt, die auf Basis dieser Informationen die spektralen Nutzsignalanteile verstärkt, die von einer Überdeckung betroffen wären. Die Verstärkung erfolgt vorzugsweise in Abhängigkeit des Ausmaßes oder des Grades der Überdeckung. So werden wenig überdeckte spektrale Nutzsignalanteile weniger verstärkt als stark oder vollständig überdeckte spektrale Nutzsignalanteile. Statt der spektralen Nutzsignalanteile werden bei einer abgewandelten Ausführung die für eine Verständlichkeit der Sprachdurchsage psychoakustisch wichtige Nutzsignalanteile verstärkt werden, wie z.B. wichtige Konsonanten oder Formanten. Eine Kombination dieser Maßnahmen stellt eine dritte Alternative dar. Zur Sicherstellung der zeitlichen Korrelation zwischen dem modifizierten Nutzsignal und dem geschätzten Störteppich ist optional ein Zwischenspeicher für eine Synchronisation der Signale vorgesehen, der für eine temporäre Zwischenspeicherung des Nutzsignals und/oder des modifizierten Nutzsignals ausgebildet ist.

Das modifizierte Nutzsignal wird an einen oder mehrere Lautsprecher 12 übergeben. Als Ergänzung der Beschallungsanlage 1 ist optional ein Dynamik-Kompressor (nicht dargestellt) vorgesehen, der den Pegel leiserer Passagen der Sprachdurchsage anhebt und lautere Passagen unbeeinflusst lässt bzw. weniger anhebt.

## Patentansprüche

1. Beschallungsanlage (1)
mit einem ersten Audioeingang (7) für Nutzsignale,
mit einem zweiten Audioeingang (6) für Störsignale,
mit einem Audioausgang für modifizierte Nutzsignale (12) und
mit einer Abgleichvorrichtung (11), die programm- und/oder schaltungstechnisch für den Abgleich der Nutzsignale mit den Störsignalen ausgebildet ist, so dass die modifizierten Nutzsignale erzeugbar sind und/oder erzeugt werden,
wobei die Beschallungsanlage (1) zur gleichmäßigen Beschallung von ausgedehnten Bereichen ausgebildet ist
**dadurch gekennzeichnet,**
**dass** die Beschallungsanlage (1) ein Schätzmodul (10) aufweist, welches zur Prädiktion der Störsignale für einen zukünftigen Zeitpunkt ausgebildet ist, wobei ein Zeitrahmen einer Prädiktionsdauer an die Zeit gekoppelt ist,
die benötigt wird, um die Nutzsignale zu modifizieren und an die Zeit für die Schallausbreitung im Raum.

2. Beschallungsanlage (1) nach Anspruch 1, **dadurch gekennzeichnet, dass** die Störsignale Informationen über die örtliche Verteilung der Störgeräusche entfalten und/oder aus derartigen Signalen gebildet sind.

3. Beschallungsanlage (1) nach Anspruch 1 oder 2, **dadurch gekennzeichnet,**
**dass** die Nutzsignale als Sprachsignale und/oder die Störsignale als Umgebungsgeräusche ausgebildet sind und/oder diese umfassen.

4. Beschallungsanlage (1) nach einem der vorhergehenden Ansprüche, **gekennzeichnet durch** eine Hauptstation (5), die den ersten Audioeingang (7) umfasst, und
eine Nebenstation (4), die die Abgleichvorrichtung (11) umfasst, wobei Hauptstation (5) und Nebenstation (4) über ein Netzwerk (2) verbunden sind.

5. Beschallungsanlage (1) nach Anspruch 4, **dadurch gekennzeichnet, dass** die Hauptstation (5) und/oder die Nebenstation (4) ein Analysemodul (8) umfasst, welches zur Erzeugung von Meta-Daten über die Nutzsignale ausgebildet sind.

6. Beschallungsanlage (1) nach einem der vorhergehenden Ansprüche, **dadurch gekennzeichnet, dass** die Nebenstation (4) ein Vorverarbeitungsmodul (9) umfasst, welches zur Vorverarbeitung und/oder Filterung und/oder Echo- oder Halleliminierung der Störsignale bzw. in den Störsignalen ausgebildet ist.

7. Beschallungsanlage (1) nach einem der vorhergehenden Ansprüche, **dadurch gekennzeichnet, dass** die Abgleichvorrichtung zur Verstärkung von spektralen und/oder psychoakustisch wichtigen Nutzsignalanteilen ausgebildet ist.

8. Beschallungsanlage (1) nach Anspruch 1, **dadurch gekennzeichnet, dass** die Beschallungsanlage (1) einen Dynamikkompressor umfasst, wobei der Dynamikkompressor leise Passagen der Nutzsignale verstärkt.

9. Verfahren zur Verbesserung der Sprachqualität und/oder Verständlichkeit von Sprachdurchsagen, **gekennzeichnet durch** die bestimmungsgemäße Verwendung der Beschallungsanlage nach einem der vorhergehenden Ansprüche.

10. Computerprogramm mit Programm-Code Mitteln, um alle Schritte des Verfahrens nach Anspruch 9. durchzuführen und/oder die Beschallungsanlage nach einem der Ansprüche 1 bis 8 anzusteuern, wenn das Programm auf einem Computer ausgeführt wird.

## Claims

1. Public address system (1)
having a first audio input (7) for useful signals,
having a second audio input (6) for noise signals,
having an audio output for modified useful signals (12) and
having a matching apparatus (11) that has programming and/or circuitry designed to match the useful signals against the noise signals, so that the modified useful signals can be produced and/or are produced,
wherein the public address system (1) is designed for uniform coverage of extensive areas,
**characterized**
**in that** the public address system (1) has an estimation module (10) that is designed to predict the noise signals for a future point in time, wherein a time frame for a prediction period is coupled to the time that is needed in order to modify the useful signals and to the time for the propagation of sound in the space.

2. Public address system (1) according to Claim 1, **characterized in that** the noise signals contain information about the spatial distribution of the noise and/or are formed from such signals.

3. Public address system (1) according to Claim 1 or 2, **characterized in that** the useful signals are in the form of and/or comprise voice signals and/or the noise signals are in the form of and/or comprise ambient noise.

4. Public address system (1) according to one of the preceding claims, **characterized by** a main station (5) that comprises the first audio input (7) and an ancillary station (4) that comprises the matching apparatus (11), wherein main station (5) and ancillary station (4) are connected via a network (2).

5. Public address system (1) according to Claim 4, **characterized in that** the main station (5) and/or the ancillary station (4) comprise(s) an analysis module (8) that is designed to produce meta data about the useful signals.

6. Public address system (1) according to one of the preceding claims, **characterized in that** the ancillary station (4) comprises a preprocessing module (9) that is designed for preprocessing and/or filtering and/or echo or reverberation elimination for the noise signals or in the noise signals.

7. Public address system (1) according to one of the preceding claims, **characterized in that** the matching apparatus is designed to amplify spectral and/or psychoacoustically important useful signal components.

8. Public address system (1) according to Claim 1, **characterized in that** the public address system (1) comprises a dynamics compressor, wherein the dynamics compressor amplifies quiet passages in the useful signals.

9. Method for improving the voice quality and/or intelligibility of voice announcements, **characterized by** the use of the public address system according to one of the preceding claims as intended.

10. Computer program having program code means in order to carry out all the steps of the method according to Claim 9 and/or to actuate the public address system according to one of Claims 1 to 8 when the program is executed on a computer.

## Revendications

1. Installation de sonorisation (1), présentant
une première entrée audio (7) pour signaux utiles,
une deuxième entrée audio (6) pour signaux parasites,
une sortie audio pour des signaux utiles modifiés (12) et
un dispositif d'équilibrage (11) configuré pour équilibrer les signaux utiles par rapport aux signaux parasites par recours à de la programmation ou à des circuits, de telle sorte que les signaux utiles modifiés puissent être formés et/ou soient formés,
l'installation de sonorisation (1) étant configurée pour sonoriser de manière uniforme sur des plages étendues,
**caractérisée en ce que**
l'installation de sonorisation (1) présente un module d'évaluation (10) configuré pour prédire les signaux parasites à un instant futur et
**en ce que** le cadre temporel de la durée de prédiction est couplé au temps nécessaire pour modifier les signaux utiles et au temps nécessaire pour la propagation du son dans l'espace.

2. Installation de sonorisation (1) selon la revendication 1, **caractérisée en ce que** les signaux parasites contiennent des informations sur la répartition spatiale des bruits parasites et/ou sont formés de ces signaux.

3. Installation de sonorisation (1) selon les revendications 1 ou 2, **caractérisée en ce que** les signaux utiles sont configurés comme signaux vocaux et/ou **en ce que** les signaux parasites sont configurés comme bruits ambiants et/ou comprennent ces derniers.

4. Installation de sonorisation (1) selon l'une des revendications précédentes, **caractérisée par** un poste principal (5) qui comporte la première entrée audio (7) et un poste secondaire (4) qui comporte le dispositif d'équilibrage (11), le poste principal (5) et le poste secondaire (4) étant raccordés par un réseau (2).

5. Installation de sonorisation (1) selon la revendication 4, **caractérisée en ce que** le poste principal (5) et/ou le poste secondaire (4) comprennent un module d'analyse (8) configuré pour former des métadonnées concernant les signaux utiles.

6. Installation de sonorisation (1) selon l'une des revendications précédentes, **caractérisée en ce que** le poste secondaire (4) comporte un module de prétraitement (9) qui est configuré pour prétraiter, filtrer et/ou éliminer l'écho ou la réverbération des signaux parasites ou présents dans les signaux parasites.

7. Installation de sonorisation (1) selon l'une des revendications précédentes, **caractérisée en ce que** le dispositif d'équilibrage est configuré pour amplifier des parties spectrales ou psycho-acoustiquement importantes des signaux utiles.

8. Installation de sonorisation (1) selon la revendication 1, **caractérisée en ce que** l'installation de sonorisation (1) comporte un compresseur dynamique, le compresseur dynamique amplifiant les passages ténus des signaux utiles.

9. Procédé d'amélioration de la qualité vocale et/ou de l'intelligibilité d'expression vocale, **caractérisé par** l'utilisation correcte de l'installation de sonorisation selon l'une des revendications précédentes.

10. Programme informatique doté de moyens de code de programme permettant de mettre en oeuvre toutes les étapes du procédé selon la revendication 9 et/ou pour commander l'installation de sonorisation selon l'une des revendications 1 à 8 lorsque le programme est exécuté sur un ordinateur.
